# EUROPÄISCHE PATENTSCHRIFT

(11) **EP 0 890 847 B1**
(45) Veröffentlichungstag und Bekanntmachung des Hinweises auf die Patenterteilung: **22.09.2004**
(21) Anmeldenummer: 98112436.5
(22) Anmeldetag: 04.07.1998
(51) Int. Cl.: G01R 33/02

(54) **Vorrichtung zur Ermittlung der magnetischen Feldstärke des Erdmagnetfeldes, insbesondere in einer Fahrzeugnavigationseinrichtung**
Apparatus for determining the earth magnetic field, in particular in a vehicle navigation system
Dispositif pour la détermination du champ magnétique terrestre, en particulier dans un système de navigation véhiculaire

(30) Priorität: 12.07.1997 DE 19729896
(43) Veröffentlichungstag der Anmeldung: 13.01.1999
(73) Patentinhaber: SIEMENS AKTIENGESELLSCHAFT, 80333 München (DE)
(72) Erfinder: Hanke, Klaus-Dieter, Dipl.-Ing. (TH), 78048 Villingen-Schwenningen (DE)

(56) Entgegenhaltungen:
- EP-A- 0 596 320
- US-A- 5 644 851
- PATENT ABSTRACTS OF JAPAN vol. 016, no. 319 (P-1385), 13. Juli 1992 (1992-07-13) & JP 04 093781 A (SEIKO INSTR INC), 26. März 1992 (1992-03-26)
- SA A DE ET AL: "A THREE-AXES FLUXGATE MAGNETOMETER WITH MULTIPLEXED SENSORS" MEASUREMENT SCIENCE AND TECHNOLOGY,GB,IOP PUBLISHING, BRISTOL, Bd. 4, Nr. 5, 1. Mai 1993 (1993-05-01), Seiten 633-634, XP000362384 ISSN: 0957-0233

## Beschreibung

Vorrichtung zur Ermittlung der magnetischen Feldstärke des Erdmagnetfeldes, insbesondere in einer Fahrzeugnavigationseinrichtung

Die Erfindung betrifft eine Vorrichtung zur Ermittlung der magnetischen Feldstärke des Erdmagnetfeldes gemäß dem Oberbegriff des ersten Anspruchs.

Die Komponenten des Erdmagnetfeldes werden bei vielen automotiven Anwendungen - wie Navigationseinrichtungen, elektronische Kompasse oder Unfalldatenspeichern - durch orthogonal zueinander angeordnete Magnetfeldsensoren erfaßt, die beispielsweise durch Spulen realisiert sind. Um das Erdmagnetfeld in zwei Raumrichtungen zu erfassen, werden demnach zwei Magnetfeldsensoren benötigt. Dabei sind die Magnetfeldsensoren in Schaltungsanordnungen eingebunden, die die Signale der Magnetfeldsensoren zu einem transportfähigen und auswertbaren Meßwert aufbereiten. Diese Schaltungsanordnungen bilden die Betriebsschaltung der Magnetfeldsensoren.

Eine gattungsgemäße Vorrichtung ist z. B aus dem Dokument US 5,644,851 bekannt. Demnach werden, um die Richtung des Erdmagnetfeldes zu bestimmen, zwei orthogonal zueinander ausgerichtete Magnetfeldsensoren abwechselnd ausgelesen und aus den gewonnenen Werten Richtung und Betrag des Erdmagnetfeldes bestimmt. Zum Einsatz kommen dabei magnetorestitive Elemente.

Eine andere Art von Magnetfeldsensoren sind aus_der Schrift DE 195 38 757 C1 bekannt. Zunächst wird die in einem Oszillator betriebene Meßspule zur Festlegung ihres Arbeitspunktes und zur Schaffung eines möglichst linearen Arbeitsbereiches magnetisch vorgespannt. Sodann wird dem Meßfeld, das heißt derjenigen Komponente des Erdmagnetfeldes in Spulenlängsrichtung, durch einen geschlossenen Regelkreis, in welchem der Oszillator die Regelstrecke bildet, ein magnetisches Kompensationsfeld überlagert, wobei der Kompensationsstrom zur Flußdichte des Meßfeldes proportional ist. Zur Eliminierung von Drifterscheinungen, insbesondere von auf das Meßsignal einwirkenden Temperaturdriften, wird die Bestromungsrichtung in den Spulen in einem zeitlichen Takt fortlaufend umgepolt. Das Meßsignal ergibt sich dann aus einer Differenzmessung des erforderlichen Kompensationsstromes für beide Magnetisierungsrichtungen. Es liegt in Form einer Folge diskreter Meßwerte vor.

Zur Erfassung von mehr als einer Komponente des Erdmagnetfeldes sind bei der beschriebenen Meßanordnung mindestens zwei, bei Einbeziehung der dritten Raumrichtung sogar drei baugleiche Betriebsschaltungen vorzusehen. Dies ist nachteilig, weil die gesamte Regelungselektronik mehrfach vorzuhalten ist.

Die beschriebene Betriebsschaltung liefert ihr Meßsignal zur weiteren Auswertung an eine Steuereinheit. Um die Genauigkeit der Messung zu erhöhen, wird eine gewisse Anzahl von aufeinanderfolgenden Meßwerten in einem der Steuereinheit zugeordneten Speicher zwischengespeichert. Sodann berechnet die Steuereinheit den Mittelwert über diese Anzahl von Meßwerten und speichert diesen Mittelwert zur weiteren Signalauswertung. Diese Vorgehensweise ist beispielsweise in der Schrift EP 0 596 320 A1 beschrieben. Bei einer kontinuierlichen Meßwerterfassung in allen Raumrichtungen erfolgt auch die Mittelwertbildung gleichzeitig und parallel für die Meßsignale aus allen Betriebsschaltungen. Hierfür sind in der Steuereinheit erhebliche Speicher- und Rechenmittel zur Verfügung zu stellen, was ebenfalls aus Kostengründen nachteilig ist. Außerdem erzeugt eine solche Vorgehensweise eine recht aufwendige, und damit speicherintensive Struktur für das Steuerprogramm. Man konnte in herkömmlichen gattungsgemäßen Vorrichtungen auf diesen Aufwand aber nicht verzichten, weil die alternative Möglichkeit der Erfassung von einzelnen Momentanwerten je Raumrichtung keine Meßergebnisse mit zufriedenstellender Genauigkeit bereitstellen kann. Eine Mittelwertbildung ist auch in dem Dokument DE 43 35 102 A1 beschrieben. Es geht dabei um die Auswertung des Signals eines Magnetfeldsensors zur Bestimmung einer einzigen Magnetfeldkomponente. Das sekundäre, von einem primären Magnetfeld in einem organischen Körper angeregte Magnetfeld wird zu Diagnosezwecken erfaßt, wobei zur Unterdrückung von Störsignalen aus mehreren, über einen längeren Zeitraum erfaßten Einzelsignalen ein Mittelwert gebildet wird.

Es ist nun die Aufgabe der vorliegenden Erfindung, eine Vorrichtung aufzuzeigen, die geeignet ist, die Komponenten des Erdmagnetfeldes genau und zeitkorreliert zu erfassen, und zwar unter besonderer Berücksichtigung der in einem Fahrzeug herrschenden Gegebenheiten. Dabei soll von einer Verwendung der beschriebenen Betriebsschaltung für einen Magnetfeldsensor ausgegangen werden. Jedoch ist zu vermeiden, die Betriebsschaltung mehrfach vorzusehen. Das Ziel besteht also darin, den baulichen und programmtechnischen Aufwand für eine gattungsgemäße Vorrichtung, und damit die Kosten für ihre Realisierung, deutlich zu reduzieren, ohne Einbussen an der Qualität der Meßwerte hinzunehmen.

Zur Lösung der Aufgabe wird eine Vorrichtung gemäß Anspruch 1 vorgeschlagen. Der Vorteil des vorgeschlagenen Verfahrens besteht darin, daß die Meßanordnung nur eine einzige Betriebsschaltung benötigt, und dennoch Meßwerte eines räumlichen Magnetfeldes zu erfassen vermag. Ferner werden keine Einzelwerte erhoben, sondern es werden je Raumrichtung bezüglich des Meßzeitpunktes mit ausreichender Genauigkeit miteinander korrelierende Mittelwerte aus kurzen Meßwertfolgen gebildet, deren Aussagegenauigkeit höher ist als die von Einzelmessungen.

Diese Vorgehensweise führt auch zu einer erheblichen Entlastung der Steuereinheit, die der Betriebsschaltung nachgeordnet ist, wobei die Entlastung insbesondere den Speicherbedarf betrifft. Der Parallelbetrieb wird in eine serielle Arbeitsweise überführt, die zu programmtechnischen Vereinfachungen und zu einer besseren Ausnutzung der vorhandenen Rechnerressourcen führt. Hier sei ausdrücklich erwähnt, daß für die beabsichtigten automotiven Anwendungen aus Kostengründen nur aller einfachste Mikrorechner zum Einsatz kommen können und die gefundene Lösung unter diesen extremen Randbedingungen zu würdigen ist.

Anhand von drei Figuren soll die vorgeschlagene Lösung verdeutlicht werden. Figur 1 zeigt ein vereinfachtes Blockschaltbild des Meßaufbaus zur Durchführung des vorgeschlagennen Verfahrens. Figur 2 zeigt die Betriebsschaltung nach DE 195 38 757 C1, die die vorliegende Lösung weiter entwickelt. Figur 3 zeigt ein Ablaufdiagramm für die Sensorsteuerung.

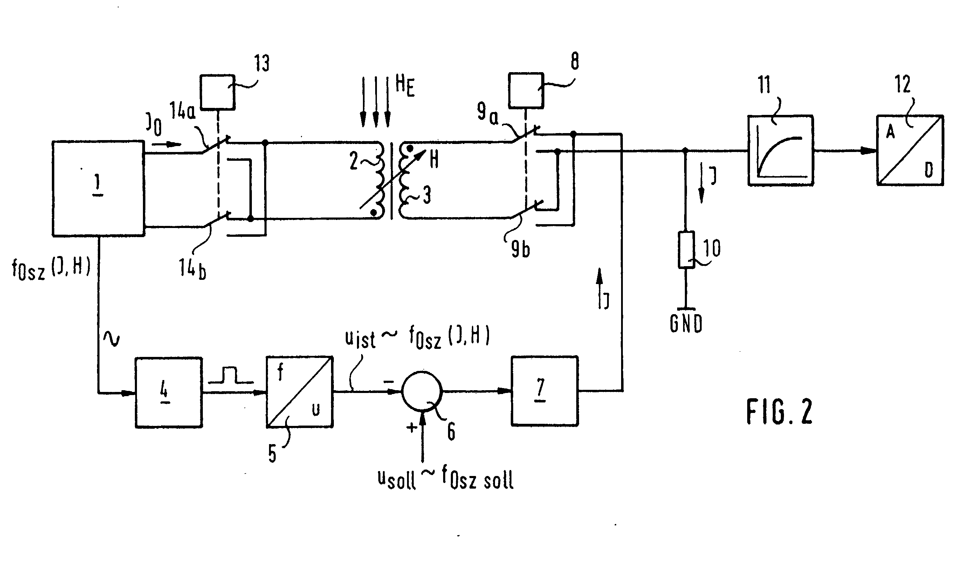

Gemäß der in der Figur 2 dargestellten Betriebsschaltung nach DE 195 38 757 C1 wird ein LC-Oszillator 1 mit einer ersten Spule 2 betrieben. Um die Oszillatorfrequenz f_{osz} trotz der Einwirkung eines äußeren Magnetfeldes HE, welches bei den vorgesehenen Anwendungen das Erdmagnetfeld ist, auf die Induktivität 2 konstant zu halten, wird die feldstärkeabhängige, sinusförmige Oszillatorfrequenz f_{osz} durch eine geeignete Anpassungsschaltung 4 in ein Rechtecksignal umgewandelt und dann einem Frequenz-Spannungsumsetzer 5 zugeleitet, dessen Ausgang mit einem Subtrahierglied 6 verbunden ist, an dem ein der momentanen Oszillatorfrequenz f_{osz} proportionaler Spannungswert uᵢₛₜ von einem fest eingestellten Spannungssollwert uₛₒₗₗ, der der idealen Sollfrequenz fₛₒₗₗ des Oszillators entspricht, subtrahiert wird. Die Sollfrequenz fₛₒₗₗ des Oszillators ist diejenige Frequenz, die der Oszillator 1 im unbelasteten Zustand, das heißt in Abwesenheit des Meßfeldes HE, in seinem Arbeitspunkt annimmt, wobei HE die Komponente des zu messenden Magnetfeldes in Spulenlängsrichtung bezeichnet. Die Differenz aus den beiden Spannungswerten usoll und uist wird einem Regler 7 zugeführt, der den Betriebsstrom 1 für die Kompensationsspule 3 derart einstellt, daß die Spannungsdifferenz (uₛₒₗₗ - uᵢₛₜ) gegen Null geht und die durch das Meßfeld HE bewirkte Veränderung der Induktivität 2 und die daraus resultierende Veränderung der Oszillatorfrequenz f_{Osz} kompensiert wird, wodurch die Oszillatorfrequenz f_{osz} je nach der Regelgeschwindigkeit des Regelkreises mehr oder weniger konstant bleibt.

Die Amplitude des Betriebsstromes 1 für die Kompensationsspule 3 ist der Stärke der Komponente des Meßfeldes HE in Spulenlängsrichtung direkt proportional und ändert sich damit gleichermaßen wie die Stärke des Meßfeldes. Die eigentliche Meßgröße ist daher durch Auswertung der Amplitude des Betriebsstromes 1 direkt ableitbar. Dazu wird der durch die Kompensationsspule 3 fließende Betriebsstrom I über einen Shuntwiderstand 10 gegen Masse GND geleitet, um den Strom I als Spannungssignal auswertbar zu machen. Da jedoch lediglich der Gleichanteil dieses Spannungssignals ein der Meßgröße proportionales Maß ist, wird das Spannungssignal über ein als Tiefpaß ausgebildetes Siebglied 11 einem Analog-Digital-Umsetzer 12 zur weiteren Verarbeitung zugeführt, die in einer nachgeordneten, in dieser Figur nicht dargestellten Steuereinheit erfolgt.

Zur Umpolung der Bestromungsrichtung der Kompensationsspule 3 werden ihre beiden elektrischen Anschlüsse an Wechselschalter 9a und 9b angeschlossen, welche durch eine Betätigung 8 zeitgleich geschaltet werden. Ebenso ist es vorteilhaft, die beiden elektrischen Anschlüsse der als Meßspule ausgebildeten Induktivität 2 über Wechselschalter 14a und 14b zu führen, die zeitgleich durch eine Betätigung 13 geschaltet werden. So wird der Betriebsstrom 10 durch die Oszillatorspule 2 wechselweise richtungsmäßig umgeschaltet, wodurch parasitäre Stromanteile des Oszillators eliminiert werden. Parasitäre Stromanteile sind Störeinflüsse, die dadurch entstehen, daß das Wechselfeld des LC-Oszillators 1 nicht ideal ist, sondern bedingt durch den schaltungstechnischen Aufbau des Oszillators von einem Gleichanteil überlagert wird, der von einem unvermeidbaren Querstrom im Oszillator 1 resultiert. In der praktischen Realisierung werden die Betätigungen 8 und 13 von der in dieser Figur nicht dargestellten Steuereinheit gesteuert.

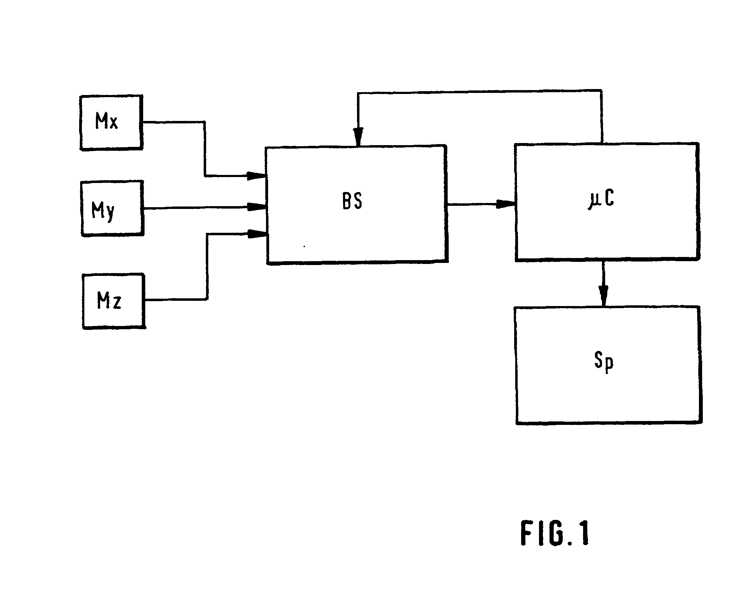

Die Figur 1 zeigt nun vereinfacht den vorgeschlagenen Meßaufbau, wobei für jede Raumrichtung ein Magnetfeldsensor Mx, My und Mz vorgesehen ist. Dabei soll jeder Magnetfeldsensor aus einer Spulenanordnung bestehen, wie sie in Figur 2 gezeigt ist. Die ferromagnetisch vorgespannte Meßspule 2 kann dazu mit der Kompensationsspule 3 überwickelt sein, wobei beide Spulen jedoch elektrisch voneinander isoliert bleiben. Es ist vorteilhaft, die Spulen gegenläufig zu wickeln. In der Betriebsschaltung BS, die dem Schaltungsaufbau nach Figur 2 entspricht, sind die Wechselschalterpaare 9a, 9b und 14a, 14b so ausgebildet, daß durch die Betätigungen 8 und 13 die Magnetfeldsensoren Mx, My und Mz zyklisch mit der Regelungselektronik der Betriebsschaltung BS verbunden werden. Die Betätigungen 8 und 13 werden dabei in einem festen Takt von einer Steuereinheit µC, die durch einen Mikrocontroller oder eine andere Logikeinheit realisiert ist, gesteuert. Sie können programmgesteuerte Schaltzustände an Ausgangsbeschaltungen des Mikrocontrollers sein, wodurch die Wechselschalterpaare 9a, 9b und 14a, 14b in eine definierte Stellung gebracht werden.

Die vorgeschlagene Vorgehensweise bringt nun den ersten Magnetfeldsensor Mx mit der Betriebsschaltung in Wirkverbindung. Sodann wird in einem bestimmten Takt eine Anzahl von n Meßwerten aufgenommen und über den A/D-Wandler 12 an die Steuereinheit µC geliefert, die daraus den Mittelwert berechnet und diesen in einem ihr zugeordneten Speicher Sp speichert. Danach schaltet die Steuereinheit µC die Bestromungsrichtung in der Meßspule 2 und der Kompensationsspule 3 um und nimmt wiederum eine bestimmte Anzahl von m Meßwerten auf, mit denen ebenso, wie zuvor beschrieben, verfahren wird. Diese Vorgehensweise wird mit den Magnetfeldsensoren My und gegebenenfalls Mz wiederholt, bevor wieder Meßwerte vom ersten Magnetfeldsensor Mx aufgenommen werden. Dabei sind der Meßtakt und die Anzahl der in einer Meßphase aufgenommenen Meßwerte so zu wählen, daß die innerhalb eines Meßzyklusses erhobenen Meßwerte im Verhältnis zum Änderungsverhalten des Meßfeldes mit ausreichender Genauigkeit korrelieren und im Hinblick auf den mit der Meßwertauswertung verfolgten Zweck als annähernd zeitgleich erfaßt gelten können.

Da die Meßspule 2 jedes beteiligten Magnetfeldsensors in einem Oszillator 1 betrieben wird, ist bei der Festlegung des Meßtaktes zur Vermeidung von Meßfehlern darauf zu achten, daß sich der Oszillator im eingeschwungenen Zustand befindet. Es ist vorteilhaft, zur Bemessung der Wartezeit zwischen der Betätigung der Wechselschalter und der Meßwerterhebung einen der Steuereinheit µC zugeordneten oder gar in ihr integrierten Timer zu verwenden, weil sich dessen Betrieb mit verhältnismäßig geringem Aufwand in das Steuerprogramm einbinden läßt.

Bei der beschriebenen Ausführung der Erfindung hat es sich als ausreichend erwiesen, wenn je Betriebsphase eines Magnetfeldsensors nur eine kleine Anzahl n bzw. m von Meßwerten aufgegriffen wird, über die dann der Mittelwert gebildet wird. Zykluszeiten bis zu einer Sekunde führen unter Berücksichtigung der Meßbedingungen, die sich durch die Erfassung des Erdmagnetfeldes in einem fahrenden Straßenfahrzeug ergeben, noch zu Meßwerten, die als zeitgleich betrachtet werden können, wodurch die für die Meßwertauswertung notwendige Zeitkorrelation der Meßwerterhebungen aus den einzelnen Betriebsphasen der Magnetfeldsensoren gewährleistet ist.

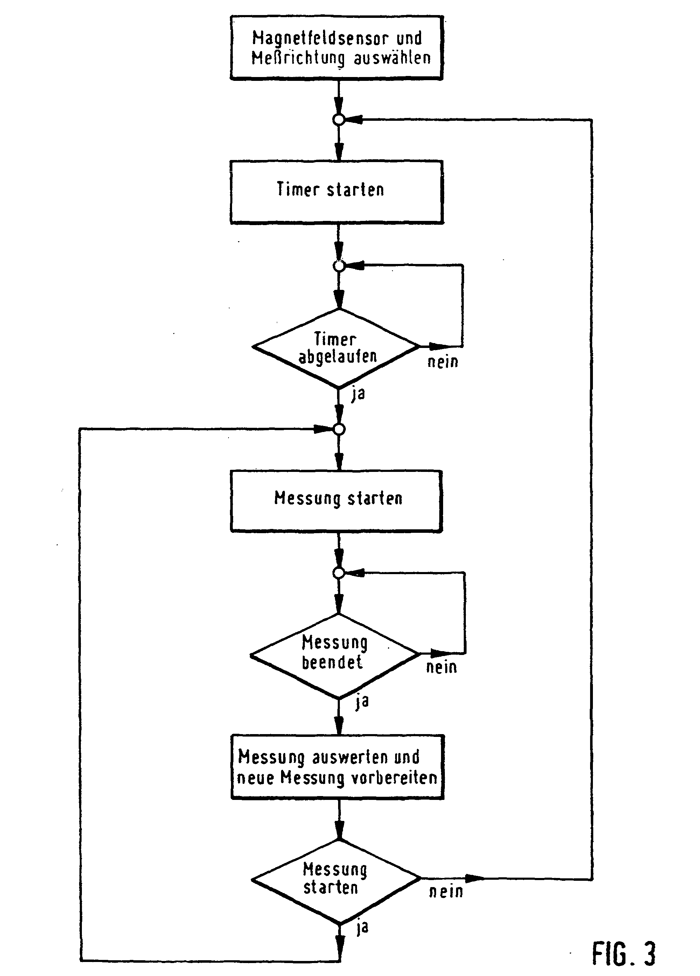

Figur 3 geht auf eine vorteilhafte Ausgestaltung der Meßroutine ein. In dem gezeigten Ablaufdiagramm für die Sensorsteuerung wählt die Steuereinheit µC zunächst einen Magnetfeldsensor aus und legt für diesen die Meßrichtung fest. Danach wird ein Timer gestartet. Nach dessen Ablauf beginnt die eigentliche Messung, indem mit dem Magnetfeldsensor erfaßte Meßwerte an die Steuereinheit µC weitergeleitet werden. Die Meßwertauswertung in der Steuereinheit µC beginnt nach Abschluß der sensorischen Meßwerterfassung und besteht zunächst in einer Ermittlung des Mittelwertes aus den soeben erfaßten Meßwerten sowie aus einer Speicherung des berechneten Mittelwertes. Danach wählt die Steuereinheit µC für eine weitere Meßwerterfassung den Magnetfeldsensor und die Meßrichtung und gibt ein Steuersignal an die Betätigungen 8 und 13 für die Schaltmittel 9a, 9b und 14a, 14b aus. Wenn die Messung wiederholt wird, ist es nicht notwendig, zunächst den Timer zu starten, da sich die Meßanordnung noch im eingeschwungenen Zustand befindet. Daher kann sofort nach der Abfrage, ob der Meßvorgang gestartet werden soll, der Befehl zu dessen Ausführung folgen. Wenn die Steuereinheit µC jedoch einen der Parameter Magnetfeldsensor oder Meßrichtung ändert, muß die Meßanordnung zunächst für die Messung vorbereitet werden, wozu auch das Starten des Timers gehört. Auf die hier beschriebene Weise werden nacheinander alle vorhandenen Magnetfeldsensoren abgearbeitet. Danach beginnt der Meßzyklus von vorne.

An der Programmstruktur fällt auf, daß zwei sich gegenseitig triggernde Kreisläufe bestehen, die unabhängig von anderen Teilen des Steuerprogramms ablaufen, denn üblicherweise wird in einer gattungsgemäßen Vorrichtung die Steuereinheit µC auch noch für weitere Aufgaben eingesetzt, z. B. zur Ansteuerung von Anzeigemitteln oder ähnlichem. Das vorgeschlagene sequentielle Vorgehen in einer Meßroutine, die von Unterbrechungen frei ist, die von äußeren Prozessen herrühren, führt unter den bestehenden Gegebenheiten zu einer optimalen Ausnutzung der Prozessorressourcen.

## Patentansprüche

1. Vorrichtung zur Ermittlung der Komponenten der magnetischen Feldstärke des Erdmagnetfeldes in einer Fahrzeugnavigationseinrichtung, mit wenigstens zwei orthogonal zueinander angeordneten Magnetfeldsensoren, die zur Ermittlung der jeweiligen Feldstärke mit einer einzigen Betriebsschaltung koppelbar sind,
wobei Schalter vorgesehen sind, die zur Erfassung der einzelnen Komponenten der jeweiligen Feldstärke die einzelnen Magnetfeldsensoren für eine bestimmte Messtaktzeit zyklisch nacheinander mit der Betriebsschaltung verbinden, wobei nach einem Zyklus die Betriebsschaltung erneut mit dem ersten Magnetfeldsensor verbunden wird und wobei die jeweils gewonnenen Messwerte von einer Steuereinheit in einem Speicher für eine nachfolgende an eine Regel einrichtung angeschlossen Messwertauswertung gespeichert werden,
**dadurch gekennzeichnet, dass**
die Vorrichtung so eingerichtet ist, dass zur Bestimmung der einzelnen Komponenten der magnetischen Feldstärke des zu messenden Feldes ein Kompensationsverfahren zum Einsatz kommt, das von der. Regeleinrichtung betrieben wird, bei der das zu messende Erdmagnetfeld durch das Magnetfeld einer Messspule kompensiert wird, und
dass die an die Betriebsschaltung angeschlossene Steuereinheit so einserichtet it, dass sie innerhalb jeder Messtaktzeit eine Folge von mehreren (n) Messwerten von dem aktuell mit der Betriebsschaltung verbundenen Magnetfeldsensor aufnimmt
und dass die Steuereinheit für eine nachfolgende Messwertauswertung den Mittelwert der innerhalb der Messtaktzeit aufgenommenen Messwerte bildet und in einem an der Steuereinheit angeschlossenen elektronischen Speicher speichert.

2. Vorrichtung nach Anspruch 1, **dadurch gekennzeichnet, dass** die Steuereinheit die zyklische Ansteuerung der Magnetfeldsensoren sowie den mit ihnen durchgeführten Messvorgang unabhängig von anderen Programmteilen vornimmt.

## Claims

1. Device for determining the components of the magnetic field strength of the earth's magnetic field in a vehicle navigation device, having at least two magnetic field sensors which are arranged orthogonally with respect to one another and which can be connected to a single operating circuit in order to determine the respective field strength, switches being provided which connect the individual magnetic field sensors for a specific measuring clock time to the operating circuit in cyclical succession in order to sense the individual components of the respective field strength, the operating circuit being connected again to the first magnetic field sensor after one cycle and the respectively acquired measured values being stored by a control unit in a memory for a subsequent measured value evaluation means which is connected to a control device, **characterized in that** the device is configured in such a way that, in order to determine the individual components of the magnetic field strength of the field which is to be measured, a compensation method is used which is operated by the control device in which the earth's magnetic field which is to be measured. is compensated by the magnetic field of a measurement coil, and **in that** the control unit which is connected to the operating circuit is configured in such a way that it records a sequence of a plurality of measured values (n) from the magnetic field sensor which is currently connected to the operating circuit, and **in that**, for a subsequent measured value evaluation, the control unit forms the mean value of the measured values recorded within the measuring clock time and stores it in an electronic memory which is connected to the control unit.

2. Device according to Claim 1, **characterized in that** the control unit cyclically actuates the magnetic field sensors and the measurement process carried out with them, independently of other program parts.

## Revendications

1. Dispositif pour la détermination des composantes de l'intensité du champ magnétique terrestre dans un système de navigation véhiculaire, comprenant au moins deux capteurs de champ magnétique placés de manière orthogonale l'un par rapport à l'autre, ceux-ci pouvant être couplés à un seul circuit de service pour déterminer l'intensité respective du champ,
des commutateurs étant prévus, qui raccordent au circuit de service chacun des capteurs de champ magnétique de manière cyclique les uns après les autres pour un certain temps de cadence de mesure pour détecter chacune des composantes de l'intensité respective du champ, le circuit de service étant à nouveau raccordé au premier capteur de champ magnétique après un cycle et les v aleurs de mesure respectivement obtenues étant mémorisées, pour une évaluation suivante, dans une mémoire par une unité de commande raccordée à un dispositif de régulation,
**caractérisé en ce que**
le dispositif est conçu de telle manière qu'un procédé de compensation est utilisé pour déterminer les différentes composantes de l'intensité magnétique du champ à mesurer, ce procédé étant exploité par le dispositif de régulation, dans lequel le champ magnétique terrestre à mesurer est compensé par le champ magnétique d'une bobine de mesure,
et **en ce que**
l'unité de commande raccordée au circuit de service est conçue de telle manière qu'elle enregistre une séquence de plusieurs (n) valeurs de mesure du capteur de champ magnétique raccordé momentanément au circuit de service pendant chaque cadence de mesure
et **en ce que** l'unité de commande forme la valeur moyenne des n valeurs de mesure enregistrées pendant la cadence de mesure pour une évaluation ultérieure de valeurs de mesure et la mémorise dans une mémoire électronique raccordée à l'unité de commande.

2. Dispositif selon la revendication 1, **caractérisé en ce que** l'unité de commande exécute la commande cyclique des capteurs de champ magnétique ainsi que l'opération de mesure réalisée par eux, en fonction d'autres parties de programme.
